(19) Europäisches Patentamt / European Patent Office / Office européen des brevets

(11) **EP 2 676 793 A1**

(12) **EUROPEAN PATENT APPLICATION**

(43) Date of publication:
**25.12.2013 Bulletin 2013/52**

(51) Int Cl.:
**B32B 25/04** (2006.01)   **H05K 7/20** (2006.01)

(21) Application number: **13171477.6**

(22) Date of filing: **11.06.2013**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **22.06.2012 JP 2012141184**

(71) Applicant: **NITTO DENKO CORPORATION**
**Ibaraki-shi, Osaka 567-8680 (JP)**

(72) Inventors:
• **Hyodo, Tomonori**
  **Ibaraki-shi, Osaka 567-8680 (JP)**

• **Soga, Masatsugu**
  **Ibaraki-shi, Osaka 567-8680 (JP)**
• **Hirao, Akira**
  **Ibaraki-shi, Osaka 567-8680 (JP)**
• **Komoto, Yusuke**
  **Ibaraki-shi, Osaka 567-8680 (JP)**
• **Maikawa, Hidetoshi**
  **Ibaraki-shi, Osaka 567-8680 (JP)**

(74) Representative: **Grünecker, Kinkeldey,**
**Stockmair & Schwanhäusser**
**Leopoldstrasse 4**
**80802 München (DE)**

(54) **Radiant heat conduction-suppressing sheet**

(57) A radiant heat conduction-suppressing sheet according to an embodiment of the present invention includes: a heat conduction-suppressing layer; and a heat conductive layer. The heat conduction-suppressing layer has a heat conductivity of 0.06 W/m·K or less. The heat conductive layer has a far-infrared absorptivity at a wavelength of 7 μm to 10 μm of 0.6 or less, and a heat conductivity of 200 W/m·K or more. The radiant heat conduction-suppressing sheet is used by being fixed to a housing containing a heating element under a state in which a side of the heat conduction-suppressing layer is fixed to the housing at such a position that the heat conductive layer faces a heat radiating surface of the heating element while being free of close contact with the heating element.

FIG. 1

EP 2 676 793 A1

**Description**

BACKGROUND OF THE INVENTION

This application claims priority under 35 U.S.C. Section 119 to Japanese Patent Application No. 2012-141184 filed on June 22, 2012, which is herein incorporated by reference.

1. Field of the Invention

The present invention relates to a radiant heat conduction-suppressing sheet.

2. Description of the Related Art

In recent years, in association with reductions in size and thickness, and improvements in performance of electronic devices such as a personal computer, a tablet PC, a PDA, a mobile phone, and a digital camera, there have been progress towards a higher density and higher integration of electronic parts, such as a CPU, an LSI, and a communication chip, which are disposed in the electronic devices, and toward higher-density mounting of the electronic parts on a printed wiring board. The reductions in thickness of the electronic devices result in a very small distance between each electronic part and a housing. Consequently, there arise problems in that a heat spot occurs on a surface of the housing owing to heat radiated from the electronic parts to the housing, and in that a user gets a low-temperature burn because of a temperature increase on the surface of the housing. In addition, in association with the higher density and higher integration of the electronic parts, a quantity of heat generated from the electronic parts increases. Consequently, there arises a problem in that the electronic devices malfunction owing to thermal runaway unless cooling is efficiently performed.

Hitherto, as an approach to efficiently release heat generated from electronic parts to the outside, there is known an approach involving providing silicone grease or silicone rubber filled with a heat conductive filler between an electronic part and a heat sink (typically constructed of aluminum, copper, an alloy thereof, or the like), thereby reducing contact thermal resistance to introduce heat into the heat sink by heat conduction, the heat being released from the heat sink into the air. Further, there is known an approach involving providing a heat pipe made of an alloy in place of the heat sink, thereby introducing heat into a cooling fan by heat conduction in the heat pipe, the heat being released from the cooling fan to the outside of the housing. The heat sink and heat pipe to be used in those approaches are each formed using a substance having a high heat conductivity. Therefore, heat release from the heat sink or heat pipe in the housing causes the temperature of the surface of the housing to increase around the electronic parts. That is, those approaches do not sufficiently solve the problem of the heat spot and the problem of the user getting a low-temperature burn.

In order to solve the problems as described above, Japanese Patent No. 3590758 proposes a heat dissipation structure in which a laminate of a heat dissipation plate and a vacuum heat insulation material is disposed between a heat-generating portion in an apparatus and a housing. Japanese Patent No. 4104887 proposes a heat dissipation structure in which a composite sheet including a heat insulation sheet and a heat conductive sheet which is formed of a flexible material which can be brought into close contact with electronic parts is disposed under a state in which the heat conductive sheet is on the side of the electronic parts and the composite sheet is in contact with both the electronic parts and the inner surface of the housing. Japanese Patent Application Laid-open No. Hei 10(1998)-229287 proposes a cooling structure including: a pressing member disposed on the inner surface of a housing so as to face an electronic part; and a heat diffusion sheet a part of which is pressed against the electronic part by means of the pressing member and another part of which is bonded to the inner surface of the housing. However, none of the technologies described in the patent literatures can sufficiently solve the problems of the temperature increase and heat spot on the surface of the housing.

SUMMARY OF THE INVENTION

The present invention has been made in order to solve the conventional problems, and an object of the present invention is to provide a radiant heat conduction-suppressing sheet which can suppress a temperature increase and the occurrence of a heat spot on the surface of a housing, can be mounted onto the housing by an extremely easy operation, and is excellent in adhesiveness for the housing.

A radiant heat conduction-suppressing sheet according to an embodiment of the present invention includes: a heat conduction-suppressing layer; and a heat conductive layer. The heat conduction-suppressing layer has a heat conductivity of 0.06 W/m·K or less. The heat conductive layer has a far-infrared absorptivity at a wavelength of 7 $\mu$m to 10 $\mu$m of 0.6 or less, and a heat conductivity of 200 W/m·K or more. The radiant heat conduction-suppressing sheet is used by being fixed to a housing containing a heating element under a state in which a side of the heat conduction-suppressing layer is fixed to the housing at such a position that the heat conductive layer faces a heat radiating surface of the heating element while being free of close contact with the heating element.

In one embodiment of the present invention, the heat conduction-suppressing layer includes a porous material including spherical cells each having an average pore diameter of 100 $\mu$m or less.

In one embodiment of the present invention, the heat conduction-suppressing layer includes a porous material having surface openings.

In one embodiment of the present invention, the heat conduction-suppressing layer includes a porous material including: spherical cells each having an average pore diameter of less than 20 $\mu$m; and through-holes between adjacent spherical cells.

In one embodiment of the present invention, the heat conduction-suppressing layer includes a hydrophilic polyurethane-based polymer.

In one embodiment of the present invention, the heat conduction-suppressing layer has a shear adhesive strength at 80°C of 10 N/cm$^2$ or more.

In one embodiment of the present invention, the heat conductive layer is selected from a graphite sheet and a metal foil.

In one embodiment of the present invention, an area of the heat conductive layer is 4 or more times as large as an area of the heat radiating surface of the heating element, which the heat conductive layer faces.

According to the present invention, the radiant heat conduction-suppressing sheet including the heat conduction-suppressing layer having the specified heat conductivity and the heat conductive layer having the specified heat conductivity and the specified far-infrared absorptivity is disposed in such a manner that the heat conductive layer faces a heating element in a housing while being free of contact with the heating element, and the side of the heat conduction-suppressing layer is fixed to the inner surface of the housing. With this, radiant heat from the heating element can be efficiently reflected by the heat conductive layer. In addition, heat transferred to the heat conductive layer by convection can be efficiently diffused in the plane direction of the heat conductive layer, and can be released to the housing while being gradually conducted in the thickness direction of the radiant heat conduction-suppressing sheet through the heat conduction-suppressing layer. Thus, even in a very small space such as one in a small electronic device, heat from a heating element can be very efficiently dissipated. As a result, a temperature increase and the occurrence of a heat spot on the surface of the housing can be satisfactorily suppressed.

Further, according to the present invention, the heat conductive layer is not brought into contact with a heating element, and hence the radiant heat reflective function of the heat conductive layer can be effectively utilized. As a result, when the quantity of heat generated from the heating element is the same, as compared to the case where heat is dissipated by only heat diffusion through contact with a heating element, the quantity of heat conducted from the heat conductive layer to the heat conduction-suppressing layer can be reduced, and hence the quantity of heat released from the heat conduction-suppressing layer to the housing can also be reduced, with the result that an excessively large temperature increase on the surface of the housing can be avoided. In addition, the use of the radiant heat conduction-suppressing sheet in a non-contact state with respect to a heating element obviates the need for causing the radiant heat conduction-suppressing sheet to follow the shape of the heating element. As a result, even when the height of the heating element varies, it is not necessary to deform the sheet in accordance with the shape of the heating element so that they are brought into close contact. Thus, a dimensional variation within the tolerance of the heating element (electronic part) can be absorbed, and hence the sheet is advantageous in terms of production efficiency and cost as well.

In addition, according to the present invention, the heat conduction-suppressing layer of the radiant heat conduction-suppressing sheet has a sufficient adhesion, and hence the sheet can be mounted onto a housing by means of the heat conduction-suppressinglayer without any use ofa pressure-sensitive adhesive or an adhesive, and can be mounted onto the housing by an extremely easy operation.

BRIEF DESCRIPTION OF THE DRAWINGS

In the accompanying drawings:

FIG. **1** is a schematic cross-sectional view of a radiant heat conduction-suppressing sheet according to one embodiment of the present invention;

FIG. **2** is a schematic cross-sectional view of a radiant heat conduction-suppressing sheet according to another embodiment of the present invention;

FIG. **3** is a schematic cross-sectional view of a radiant heat conduction-suppressing sheet according to still another embodiment of the present invention;

FIG. **4** is a schematic cross-sectional view of a radiant heat conduction-suppressing sheet according to still another embodiment of the present invention;

FIG. **5** is a schematic view of measurement of a heat conductivity related to the present invention;

FIG. **6** is a schematic view of measurement of a radiant heat conduction suppressive effect related to the present invention; and

FIG. **7** is a photographic view of a cross-sectional SEM photograph of a heat conduction-suppressing layer obtained in Examples, the photographic view clearly showing an open-cell structure in which through-holes are present between adjacent spherical cells.

DETAILED DESCRIPTION OF THE PREFERRED EMBODIMENTS

A. Outline of radiant heat conduction-suppressing sheet

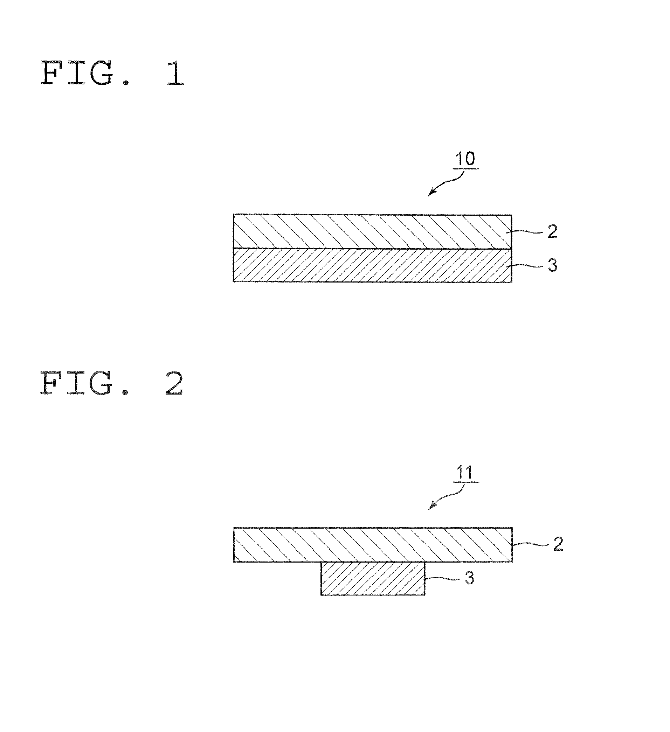

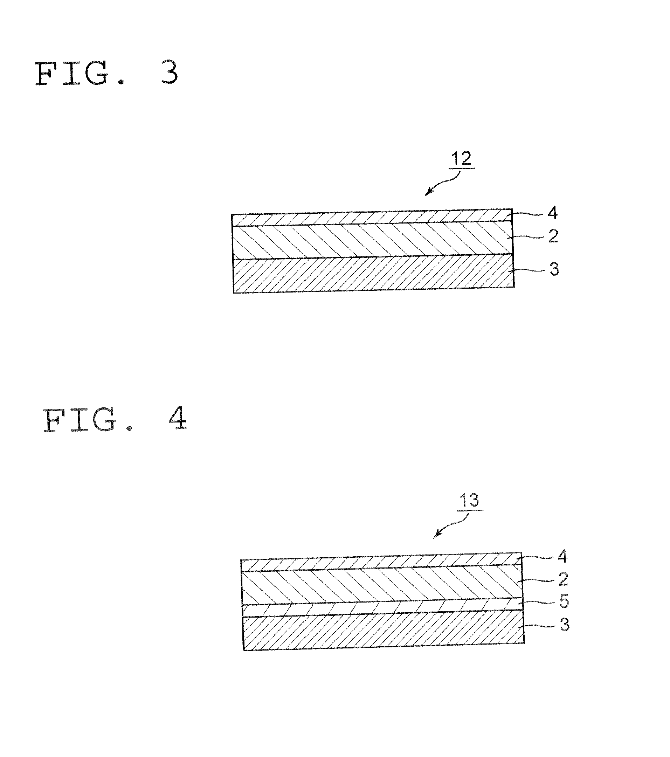

A radiant heat conduction-suppressing sheet according to an embodiment of the present invention includes a heat conduction-suppressing layer and a heat conductive layer. As typical structures of the radiant heat conduction-suppressing sheet of the present invention, there are given a radiant heat conduction-suppressing sheet **10** including a heat conduction-suppressing layer **2** and a heat conductive layer 3 having substantially the same size (FIG. **1**), and a radiant heat conduction-suppressing sheet **11** including the heat conduction-suppressing layer **2** and the heat conductive layer 3 having different sizes (FIG. **2**). In addition, the radiant heat conduction-suppressing sheet may include a pressure-sensitive adhesive layer and/or an adhesion layer. Typical examples of such construction include a radiant heat conduction-suppressing sheet **12** including a pressure-sensitive adhesive layer **4** on the side of the heat conduction-suppressing layer **2** opposite to the heat conductive layer 3 (FIG. **3**), and a radiant heat conduction-suppressing sheet **13** including an adhesion layer **5** between the heat conduction-suppressing layer **2** and the heat conductive layer **3,** and the pressure-sensitive adhesive layer **4** on the outer side of the heat conduction-suppressing layer **2** (FIG. **4**). It should be noted that the typical forms given above as examples may be appropriately combined or modified. For example, a pressure-sensitive adhesive layer or an adhesion layer may be provided between the heat conduction-suppressing layer and heat conductive layer in each of FIG. **1** to FIG. **3,** the heat conduction-suppressing layer and heat conductive layer in FIG. **4** may be directly laminated, or a relationship between the sizes of the heat conduction-suppressing layer and heat conductive layer in FIG. **2** may be changed depending on purposes. The radiant heat conduction-suppressing sheet of the present invention may have any appropriate shape. The thickness and lengths such as long and short side lengths of the radiant heat conduction-suppressing sheet of the present invention may each be any appropriate value.

B. Heat conduction-suppressing layer

In the radiant heat conduction-suppressing sheet according to the embodiment of the present invention, the heat conductivity of the heat conduction-suppressing layer **2** is set small. With this, heat transferred from a heating element to the heat conductive layer **3** by convection can be efficiently diffused in the plane direction of the heat conductive layer **3**. As a result, the heat transferred to the heat conductive layer **3** can be released to the housing while being gradually conducted in the thickness direction of the radiant heat conduction-suppressing sheet through the heat conduction-suppressing layer. Such heat conduction-suppressing layer is particularly effective when the heat conductive layer **3** has an isotropic heat conductivity (no difference in heat conductivity is observed depending on different directions).

The heat conductivity of the heat conduction-suppressing layer as measured by a steady-state method is 0.06 W/m·K or less, preferably 0.055 W/m·K or less, more preferably 0.05 W/m·K or less. When the heat conductivity of the heat conduction-suppressing layer is more than 0.06 W/m·K, heat transferred from a heating element to the heat conductive layer by convection is rapidly conducted in the plane direction of the heat conductive layer, and hence suppressive effect on an temperature increase and on a heat spot on the surface of a housing may be deteriorated in many cases.

The heat conduction-suppressing layer is preferably a porous material. Such porous material preferably has voids.

The porous material which serves as the heat conduction-suppressing layer preferably includes spherical cells. The spherical cells do not need to be true spherical cells in a strict sense, and for example, may be substantially spherical cells each partially having a strain or cells each formed of a space having a large strain.

The spherical cells which may be present in the porous material which serves as the heat conduction-suppressing layer each have an average pore diameter of preferably less than 100 μm, more preferably less than 50 μm, still more preferably less than 20 μm. The lower limit value of the average pore diameter of each of the spherical cells which may be present in the porous material is, for example, preferably 0.01 μm or more, more preferably 0.1 μm or more, still more preferably 1 μm or more. When the average pore diameter of each of the spherical cells which may be present in the porous material falls within the range, the average pore diameter of each of the spherical cells of the porous material can be precisely controlled to a small one, and thus there can be provided a radiant heat conduction-suppressing sheet which can be produced as a thin film.

The porous material which serves as the heat conduction-suppressing layer preferably has surface openings on the surface . The surface openings each have an average pore diameter of preferably 100 $\mu$m or less, more preferably 50 $\mu$m or less, still more preferably 20 $\mu$m or less, particularly preferably 10 $\mu$m or less, most preferably 5 $\mu$m or less. The lower limit value of the average pore diameter of each of the surface openings is, for example, preferably 0.001 $\mu$m or more, more preferably 0.01 $\mu$m or more. When the porous material has surface openings and the average pore diameter of each of the surface openings falls within the range, an area to be brought into contact with the heat conductive layer can be reduced. Hence, contact thermal resistance can be increased, and very excellent heat diffusion property can be expressed for heat diffusion in the heat conductive layer in its plane direction. In addition, each of the surface openings plays a role as a micro absorbent, and thus there can be provided a radiant heat conduction-suppressing sheet including a heat conduction-suppressinglayer whichitselfhasasufficient adhesion. Such radiant heat conduction-suppressing sheet can be mounted onto a housing via the heat conduction-suppressing layer without any use of, for example, a pressure-sensitive adhesive layer, and can be mounted onto the housing by an extremely easy operation.

The porous material which serves as the heat conduction-suppressing layer preferably has an open-cell structure in which through-holes are present between adjacent spherical cells. The through-holes each have an average pore diameter of preferably 5 $\mu$m or less, more preferably 4 $\mu$m or less, still more preferably 3 $\mu$m or less. The lower limit value of the average pore diameter of each of the through-holes present between the adjacent spherical cells is not particularly limited, and for example, is preferably 0.001 $\mu$m, more preferably 0.01 $\mu$m. When the average pore diameter of each of the through-holes present between the adjacent spherical cells falls within the range, inclusion of air upon lamination of a pressure-sensitive adhesive, upon lamination to a heat conductive layer, or upon attachment of a radiant heat conduction-suppressing  sheet to the inner surface of a housing can be suppressed while the airtightness of the inside of the porous material necessary for an absorbent effect is maintained. Thus, there can be provided a radiant heat conduction-suppressing sheet which can be easily formed into a shape and can be easily fixed to the inner surface of a housing. It should be noted that the open-cell structure may be an open-cell structure in which through-holes are present between most or all of adjacent spherical cells, or may be a semi-closed and semi-open-cell structure in which the number of the through-holes is relatively small.

The porous material which serves as the heat conduction-suppressing layer has a cell content of preferably 30% or more, more preferably 40% or more, still more preferably 50% or more. When the cell content of the porous material which serves as the heat conduction-suppressing layer falls within the range, excellent heat conduction-suppressing performance can be achieved.

The porous material which serves as the heat conduction-suppressing layer has a density of preferably 0.08 g/cm$^3$ to 0.6 g/cm$^3$, more preferably 0.09 g/cm$^3$ to 0.5 g/cm$^3$, still more preferably 0.1 g/cm$^3$ to 0.4 g/cm$^3$. When the density of the porous material falls within the range, excellent heat conduction-suppressing performance can be achieved.

The porous material which serves as the heat conduction-suppressing layer has a shear adhesive strength at 80°C of preferably 1 N/cm$^2$ or more, more preferably 3 N/cm$^2$ or more, still more preferably 5 N/cm$^2$ or more, still more preferably 7 N/cm$^2$ or more, particularly preferably 9 N/cm$^2$ or more, most preferably 10 N/cm$^2$ or more . When the shear adhesive strength of the porous material falls within the range, a heat conduction-suppressing layer having a sufficient adhesion can be obtained, and hence the radiant heat conduction-suppressing sheet can be mounted to a housing without any use of a pressure-sensitive adhesive or an adhesive.

The thickness of the heat conduction-suppressing layer may be adjusted to any appropriate thickness depending on purposes. The thickness of the heat conduction-suppressing layer is preferably 0.5 mm or less, more preferably 0.2 mm or less, still more preferably 0.1mm or less . When the thickness of the heat conduction-suppressing layer is more than 0.5 mm, it may be difficult to introduce the radiant heat conduction-suppressing sheet into electronic devices whose thicknesses are being made smaller and smaller under a non-contact condition.

The porous material which serves as the heat conduction-suppressing layer preferably contains a hydrophilic polyurethane-based polymer. When the porous material contains the hydrophilic polyurethane-based polymer, its cell structure can be  precisely controlled, and thus there can be formed a heat conduction-suppressing layer which has a high cell content, has a smooth surface, and has a number of precisely controlled fine surface openings. As a result, very excellent heat conduction-suppressing performance and adhesiveness performance can be achieved. It should be noted that details of the hydrophilic polyurethane-based polymer are mentioned below in the description of a production method.

C. Production method for heat conduction-suppressing layer

The heat conduction-suppressing layer may be produced by any appropriate method. The heat conduction-suppressing layer may be preferably produced by forming a W/O type emulsion into a shape and polymerizing the emulsion.

As a production method for the heat conduction-suppressing layer, for example, there is given a "continuous method" involving continuously supplying an emulsifying machine with a continuous oil phase component and an aqueous phase component to prepare a W/O type emulsion which may be used for obtaining the heat conduction-suppressing layer, subsequently polymerizing the resultant W/O type emulsion to produce a water-containing polymer, and subsequently dehydrating the resultant water-containing polymer.

As another production method for the heat conduction-suppressing layer, for example, there is given a "batch method" involving feeding an emulsifying machine with an appropriate amount of an aqueous phase component with respect to a continuous oil phase component, continuously supplying the aqueous phase component with stirring to prepare a W/O type emulsion which may be used for obtaining the heat conduction-suppressing layer, polymerizing the resultant W/O type emulsion to produce a water-containing polymer, and subsequently dehydrating the resultant water-containing polymer.

A "continuous method" involving continuously polymerizing the W/O type emulsion is a preferred method because its production efficiency is high and an effect of shortening a polymerization time and shortening of a polymerization apparatus can be most effectively utilized.

More specifically, the heat conduction-suppressing layer may be preferably produced by a production method involving:

a step (I) of preparing a W/O type emulsion which may be used for obtaining the heat conduction-suppressing layer;
a step (II) of forming the resultant W/O type emulsion into a shape;
a step (III) of polymerizing the W/O type emulsion formed into a shape; and
a step (IV) of dehydrating the resultant water-containing polymer.

Herein, at least part of the step (II) of forming the resultant W/O type emulsion into a shape and the step (III) of polymerizing the W/O type emulsion formed into a shape may be simultaneously performed.

C-1. Step (I) of preparing W/O type emulsion

The W/O type emulsion which may be used for obtaining the heat conduction-suppressing layer is a W/O type emulsion including a continuous oil phase component and an aqueous phase component immiscible with the continuous oil phase component. More specifically, the W/O type emulsion is obtained by dispersing the aqueous phase component in the continuous oil phase component.

The ratio of the aqueous phase component to the continuous oil phase component in the W/O type emulsion may be any appropriate ratio in such a range that the W/O type emulsion can be formed. The ratio of the aqueous phase component to the continuous oil phase component in the W/O type emulsion can serve as an important factor for determining structural, mechanical, and performance characteristics of a porous material to be obtained by the polymerization of the W/O type emulsion. Specifically, the ratio of the aqueous phase component to the continuous oil phase component in the W/O type emulsion can serve as an important factor for determining, for example, the density, cell size, cell structure, and dimensions of a wall body for forming a porous structure of a porous material to be obtained by the polymerization of the W/O type emulsion.

The lower limit value of the ratio of the aqueous phase component in the W/O type emulsion is preferably 30 wt%, more preferably 40 wt%, still more preferably 50 wt%, particularly preferably 55 wt%. The upper limit value of the ratio of the aqueous phase component in the W/O type emulsion is preferably 95 wt%, more preferably 90 wt%, still more preferably 85 wt%, particularly preferably 80 wt%. When the ratio of the aqueous phase component in the W/O type emulsion falls within the range, the effects of the present invention can be sufficiently expressed.

The W/O type emulsion may include any appropriate additive in such a range that the effects of the present invention are not impaired. Examples of such additive include: a tackifier resin; talc; fillers such as calcium carbonate, silicic acid and salts thereof, clay, mica powder, zinc oxide, bentonite, carbon black, silica, and acetylene black; a pigment; and a dye. Such additives may be used alone or in combination.

Any appropriate method may be adopted as a production method for the W/O type emulsion. Examples of the production method for the W/O type emulsion include: a "continuous method" involving forming the W/O type emulsion by continuously supplying an emulsifying machine with a continuous oil phase component and an aqueous phase component; and a "batch method" involving forming the W/O type emulsion by feeding an emulsifying machine with an appropriate amount of an aqueous phase component with respect to a continuous oil phase component and continuously supplying the emulsifying machine with the aqueous phase component with stirring.

In the production of the W/O type emulsion, as shearing means for obtaining an emulsion state, for example, there is given application of a high shearing condition using a rotor/stator mixer, a homogenizer, or a microfluidization apparatus. Further, as another shearing means for obtaining an emulsion state, for example, there is given shaking using an impeller mixer or a pin mixer, or gentle mixing of a continuous and dispersion phase through application of a low shearing condition using an electromagnetic stirrer bar.

As an apparatus for preparing the W/O type emulsion by the "continuous method," for example, there are given a static mixer, a rotor/stator mixer, and a pin mixer. It is also possible to achieve more vigorous stirring by increasing a stirring speed or by using an apparatus designed so as to disperse the aqueous phase component more finely in the W/O type emulsion in a mixing method.

As an apparatus for preparing the W/O type emulsion by the "batch method," for example, there are given, mixing or shaking by hand, a driven impeller mixer, and a three-propeller mixing blade. Specifically, a W/O type emulsion of interest can be produced under reduced pressure through use of "T.K. AGI HOMO MIXER (trade name) " or "T.K. COMBI MIX (trade name) "manufactured by PRIMIX Corporation, or the like, which significantly reduces the amount of air bubbles included in the W/O type emulsion to be obtained.

Any appropriate method may be adopted as a preparation method for the continuous oil phase component. Typical preferred examples of the preparation method for the continuous oil phase component include a preparation method for a continuous oil phase component involving preparing a mixed syrup including a hydrophilic polyurethane-based polymer and an ethylenically unsaturated monomer and subsequently compounding the mixed syrup with a polymerization initiator, a cross-linking agent, and any other appropriate component.

Any appropriate method may be adopted as a preparation method for the hydrophilic polyurethane-based polymer. Typical examples of the preparation method for the hydrophilic polyurethane-based polymer include a preparation method involving subjecting polyoxyethylene polyoxypropylene glycol and a diisocyanate compound to a reaction in the presence of a urethane reaction catalyst.

C-1-1. Aqueous phase component

Anyaqueous fluid substantially immiscible with the continuous oil phase component may be adopted as the aqueous phase component. Water such as ion-exchanged water is preferred from the viewpoints of ease of handling and low cost.

The aqueous phase component may include any appropriate additive in such a range that the effects of the present invention are not impaired. The additives which may be included in the aqueous phase component may be used alone or in combination. Examples of such additive include a polymerization initiator and a water-soluble salt. The water-soluble salt can serve as an effective additive for additionally stabilizing the W/O type emulsion. Examples of such water-soluble salt include sodium carbonate, calcium carbonate, potassium carbonate, sodium phosphate, calcium phosphate, potassium phosphate, sodium chloride, and potassium chloride. Suchadditives may be used alone or in combination.

C-1-2. Continuous oil phase component

The continuous oil phase component preferably includes a hydrophilic polyurethane-based polymer and an ethylenically unsaturated monomer. The content of the hydrophilic polyurethane-based polymer or the ethylenically unsaturated monomer in the continuous oil phase component may be any appropriate content in such a range that the effects of the present invention are not impaired.

The content of the hydrophilic polyurethane-based polymer or the ethylenically unsaturated monomer in the continuous oil phase component, which depends on the ratio of polyoxyethylene in a polyoxyethylene polyoxypropylene glycol unit constituting the hydrophilic polyurethane-based polymer or the amount of the aqueous phase component to be compounded, is as described below, for example. The hydrophilic polyurethane-based polymer is preferably contained in the range of 10 parts by weight to 30 parts by weight with respect to 70 parts by weight to 90 parts by weight of the ethylenically unsaturated monomer, and the hydrophilic polyurethane-based polymer is more preferably contained in the range of 10 parts by weight to 25 parts by weight with respect to 75 parts by weight to 90 parts by weight of the ethylenically unsaturated monomer. Further, the hydrophilic polyurethane-based polymer is preferably contained in the range of 1 part by weight to 30 parts by weight, and the hydrophilic polyurethane-based polymer is more preferably contained in the range of 1 part by weight to 25 parts by weight, with respect to 100 parts by weight of the aqueous phase component. When the content of the hydrophilic polyurethane-based polymer falls within the range, the effects of the present invention can be sufficiently expressed.

C-1-2-1. Hydrophilic polyurethane-based polymer

The hydrophilic polyurethane-based polymer preferably includes a polyoxyethylene polyoxypropylene unit derived from polyoxyethylene polyoxypropylene glycol, and the polyoxyethylene polyoxypropylene unit preferably contains 5 wt% to 25 wt% of polyoxyethylene.

The content of the polyoxyethylene in the polyoxyethylene polyoxypropylene unit is preferably 5 wt% to 25 wt% as described above, the lower limit value thereof is more preferably 10 wt%, and the upper limit value thereof is more preferably 25 wt%, still more preferably 20 wt%. The polyoxyethylene in the polyoxyethylene polyoxypropylene unit can express an effect of stably dispersing an aqueous phase component in a continuous oil phase component. When the content of the polyoxyethylene in the polyoxyethylene polyoxypropylene unit is less than 5 wt%, it may become difficult to stably disperse the aqueous phase component in the continuous oil phase component. When the content of the polyoxyethylene in the polyoxyethylene polyoxypropylene unit is more than 25 wt%, as the condition becomes closer to an HIPE condition, phase transition from a W/O type emulsion to an oil-in-water type (O/W type) emulsion may occur.

A conventional hydrophilic polyurethane-based polymer is obtained by subjecting a diisocyanate compound, a hydrophobic long-chain diol, polyoxyethylene glycol and a derivative thereof, and a low-molecular active hydrogen compound (chain extension agent) to a reaction. However, the number of polyoxyethylene groups included in the hydrophilic polyurethane-based polymer obtained by such method is non-uniform, and hence a W/O type emulsion including such hydrophilic polyurethane-based polymer may have lowered emulsification stability. On the other hand, the hydrophilic polyurethane-based polymer included in the continuous oil phase component of the W/O type emulsion which may be used for obtaining the heat conduction-suppressing layer in the present invention has such a characteristic structure as described above. Hence, in the case where the hydrophilic polyurethane-based polymer is incorporated into the continuous oil phase component of the W/O type emulsion, excellent emulsifiability and excellent static storage stability can be expressed even when an emulsifying agent or the like is not positively added.

The hydrophilic polyurethane-based polymer is preferably obtained by subjecting polyoxyethylene polyoxypropylene glycol and a diisocyanate compound to a reaction. In this case, the lower limit value of the ratio of the polyoxyethylene polyoxypropylene glycol and the diisocyanate compound in terms of NCO/OH (equivalent ratio) is preferably 1, more preferably 1.2, still more preferably 1.4, particularly preferably 1.6, and the upper limit value thereof is preferably 3, more preferably 2.5, still more preferably 2. When the ratio in terms of NCO/OH (equivalent ratio) is less than 1, a gelled product may be liable to be generated in the production of the hydrophilic polyurethane-based polymer. When the ratio in terms of NCO/OH (equivalent ratio) is more than 3, the remaining amount of the diisocyanate compound increases, which may make the W/O type emulsion which may be used for obtaining the heat conduction-suppressing layer in the present invention unstable.

Examples of the polyoxyethylene polyoxypropylene glycol include polyether polyols manufactured by ADEKA CORPORATION (ADEKA (trademark) Pluronic L-31, L-61, L-71, L-101, L-121, L-42, L-62, L-72, L-122, 25R-1, 25R-2, and 17R-2), and polyoxyethylene polyoxypropylene glycols manufactured by NOF CORPORATION (PLONON (trademark) 052, 102, and 202). The polyoxyethylene polyoxypropylene glycols may be used alone or in combination.

Examples of the diisocyanate compound include aromatic, aliphatic, and alicyclic diisocyanates, dimers and trimers of these diisocyanates, and polyphenylmethane polyisocyanate. Examples of the aromatic, aliphatic, and alicyclic diisocyanates include tolylene diisocyanate, diphenylmethane diisocyanate, hexamethylene diisocyanate, xylylene diisocyanate, hydrogenated xylylene diisocyanate, isophorone diisocyanate, hydrogenated diphenylmethane diisocyanate, 1,5-naphthylene diisocyanate, 1,3-phenylene diisocyanate, 1,4-phenylene diisocyanate, butane-1,4-diisocyanate, 2,2,4-trimethylhexamethylene diisocyanate, 2,4,4-trimethylhexamethylene diisocyanate, cyclohexane-1,4-diisocyanate,

dicyclohexylmethane-4,4-diisocyanate,

1,3-bis(isocyanatomethyl)cyclohexane, methylcyclohexane diisocyanate, and m-tetramethylxylylene diisocyanate. Examples of the trimers of the diisocyanates include an isocyanurate type, a biuret type, and an allophanate type. The diisocyanate compounds may be used alone or in combination.

The kind, combination, or the like of the diisocyanate compounds may be appropriately selected from the viewpoint of, for example, urethane reactivity with polyol. An alicyclic diisocyanate is preferably used from the viewpoints of, for example, rapid urethane reactivity with polyol and suppression of a reaction with water.

The lower limit value of the weight average molecular weight of the hydrophilic polyurethane-based polymer is preferably 5,000, more preferably 7,000, still more preferably 8,000, particularly preferably 10,000, and the upper limit value thereof is preferably 50,000, more preferably 40,000, still more preferably 30,000, particularly preferably 20,000.

The hydrophilic polyurethane-based polymer may have a radically polymerizable unsaturated double bond at a terminal thereof. By virtue of the fact that the hydrophilic polyurethane-based polymer has a radically polymerizable unsaturated double bond at a terminal thereof, the effects of the present invention can be additionally expressed.

C-1-2-1-2. Ethylenically unsaturated monomer

Any appropriate monomer may be adopted as the ethylenically unsaturated monomer as long as the monomer has an ethylenically unsaturated double bond. The ethylenically unsaturated monomers may be used alone or in combination.

The ethylenically unsaturated monomer preferably includes a (meth)acrylic acid ester. The lower limit value of the content of the (meth)acrylic acid ester in the ethylenically unsaturated monomer is preferably 80 wt%, more preferably 85 wt%, and the upper limit value thereof is preferably 100 wt%, more preferably 98 wt%. The (meth)acrylic acid esters may be used alone or in combination.

The (meth)acrylic acid ester is preferably an alkyl (meth)acrylate having an alkyl group (concept encompassing a cycloalkyl group, an alkyl(cycloalkyl) group, and a (cycloalkyl)alkyl group as well) having 1 to 20 carbon atoms. The alkyl group preferably has 4 to 18 carbon atoms.

It should be noted that the term "(meth) acrylic" as used herein means acrylic and/or methacrylic, and the term "(meth)acrylate" as used herein means acrylate and/or methacrylate.

Examples of the alkyl (meth)acrylate having an alkyl group having 1 to 20 carbon atoms include methyl (meth) acrylate, ethyl (meth) acrylate, propyl (meth) acrylate, n-butyl (meth) acrylate, s-butyl (meth)acrylate, t-butyl (meth) acrylate, isobutyl (meth)acrylate, n-pentyl (meth)acrylate, isopentyl (meth)acrylate, hexyl (meth)acrylate, heptyl (meth) acrylate, isoamyl (meth)acrylate, 2-ethylhexyl (meth)acrylate, n-octyl (meth)acrylate, isooctyl (meth)acrylate, n-nonyl (meth)acrylate, isononyl (meth)acrylate, n-decyl (meth)acrylate, isodecyl (meth) acrylate, n-dodecyl (meth) acrylate, isomyristyl (meth)acrylate, n-tridecyl (meth)acrylate, n-tetradecyl (meth)acrylate, stearyl (meth)acrylate, lauryl (meth) acrylate, pentadecyl (meth)acrylate, hexadecyl (meth)acrylate, heptadecyl (meth)acrylate, octadecyl (meth)acrylate, nonadecyl (meth)acrylate, eicosyl (meth)acrylate, isostearyl (meth)acrylate, and isobornyl (meth)acrylate. Of those, n-butyl (meth)acrylate, 2-ethylhexyl (meth)acrylate, and isobornyl (meth)acrylate are preferred. The alkyl (meth)acrylates each having an alkyl group having 1 to 20 carbon atoms may be used alone or in combination.

The ethylenically unsaturated monomer preferably further contains a polar monomer copolymerizable with the (meth)acrylic acid ester. When the ethylenically unsaturated monomer contains the polar monomer, the effects of the present invention can be even further expressed. The lower limit value of the content of the polar monomer in the ethylenically unsaturated monomer is preferably 0 wt%, more preferably 2 wt%, and the upper limit value thereof is preferably 20 wt%, more preferably 15 wt%. The polar monomers may be used alone or in combination.

Examples of the polar monomer include: carboxyl group-containing monomers such as (meth) acrylic acid, carboxyethyl (meth)acrylate, carboxypentyl (meth)acrylate, $\omega$-carboxy-polycaprolactone monoacrylate, phthalic acid monohydroxyethylacrylate, itaconicacid, maleicacid, fumaricacid, and crotonic acid; acid anhydride monomers such as maleic anhydride and itaconic anhydride; hydroxyl group-containing monomers such as 2-hydroxyethyl (meth)acrylate, 2-hydroxypropyl (meth)acrylate, 4-hydroxybutyl (meth)acrylate, 6-hydroxyhexyl (meth)acrylate, 8-hydroxyoctyl (meth) acrylate, 10-hydroxydecyl (meth)acrylate, 12-hydroxylauryl (meth) acrylate, and (4-hydroxymethylcyclohexyl)methyl (meth)acrylate; and amide group-containing monomers such as N,N-dimethyl(meth)acrylamide, N,N-diethyl(meth)acrylamide, and hydroxyethyl(meth)acrylamide.

C-1-2-1-3. Polymerization initiator

The continuous oil phase component preferably includes a polymerization initiator.

Examples of the polymerization initiator include a radical polymerization initiator and a redox polymerization initiator. Examples of the radical polymerization initiator include a thermal polymerization initiator and a photopolymerization initiator.

Examples of the thermal polymerization initiator include an azo compound, a peroxide, peroxycarbonic acid, a peroxycarboxylic acid, potassium persulfate, t-butyl peroxyisobutyrate, and 2,2'-azobisisobutyronitrile.

Examples of the photopolymerization initiator may include: acetophenone-based photopolymerization initiators such as 4-(2-hydroxyethoxy)phenyl (2-hydroxy-2-propyl) ketone (e.g., a product available under the trade name Darocur-2959 from Ciba Japan), $\alpha$-hydroxy-$\alpha$,$\alpha$'-dimethylacetophenone (e.g., a product available under the trade name Darocur-1173 from Ciba Japan), methoxyacetophenone, 2,2-dimethoxy-2-phenylacetophenone (e.g., a product available under the trade name Irgacure-651 from Ciba Japan), and 2-hydroxy-2-cyclohexylacetophenone (e.g., a product available under the trade name Irgacure-184 from Ciba Japan); ketal-based photopolymerization initiators such as benzyl dimethyl ketal; other halogenated ketones; and acylphosphine oxides (e.g., a product available under the trade name Irgacure-819 from Ciba Japan).

The polymerization initiators may be used alone or in combination.

The lower limit value of the content of the polymerization initiator is preferably 0.05wt%, more preferably 0.1 wt%, and the upper limit value thereof is preferably 5.0 wt%, more preferably 1.0 wt%, with respect to the whole continuous oil phase component. When the content of the polymerization initiator is less than 0.05 wt% with respect to the whole continuous oil phase component, the amount of unreacted monomer components increases, with the result that the amount of monomers remaining in a heat conduction-suppressing layer to be obtained may increase. When the content of the polymerization initiator is more than 5.0 wt% with respect to the whole continuous oil phase component, the mechanical physical properties of a heat conduction-suppressing layer to be obtained may lower.

It should be noted that the amount of radicals generated by the photopolymerization initiator varies depending on, for example, the kind, intensity, and irradiation time of irradiation light and the amount of dissolved oxygen in a mixture of a monomer and a solvent as well. In addition, when the amount of dissolved oxygen is large, the amount of radicals generated by the photopolymerization initiator is suppressed, and thus polymerization does not sufficiently proceed, with the result that the amount of an unreacted product may increase. Accordingly, it is preferred to blow inert gas such as nitrogen into a reaction system to replace oxygen by the inert gas or to perform degassing by reduced pressure treatment in advance before photoirradiation.

C-1-2-1-4. Cross-linking agent

The continuous oil phase component preferably includes a cross-linking agent.

The cross-linking agent is typically used for constructing a more three-dimensional molecular structure by linking polymer chains together. The selection of the kind and content of the cross-linking agent is influenced by structural characteristics, mechanical characteristics, and fluid treatment characteristics desired for a heat conduction-suppressing layer to be obtained. The selection of the specific kind and content of the cross-linking agent is important for realizing a desired combination of the structural characteristics, mechanical characteristics, and fluid treatment characteristics of the heat conduction-suppressing layer.

In the production of the heat conduction-suppressing layer, it is preferred to use, as the cross-linking agent, at least two kinds of cross-linking agents having different weight average molecular weights.

In the production of the heat conduction-suppressing layer, it is more preferred to use, as the cross-linking agent, "one or more kinds selected from a polyfunctional (meth)acrylate, a polyfunctional (meth)acrylamide, and a polymerization-reactive oligomer each having a weight average molecular weight of 800 or more" in combination with "one or more kinds selected from a polyfunctional (meth)acrylate and a polyfunctional (meth) acrylamide each having a weight average molecular weight of 500 or less." Herein, the polyfunctional (meth)acrylate specifically refers to a polyfunctional (meth)acrylate having at least two ethylenically unsaturated groups per molecule, and the polyfunctional (meth)acrylamide specifically refers to a polyfunctional (meth)acrylamide having at least two ethylenically unsaturated groups per molecule.

Examples of the polyfunctional (meth)acrylate include diacrylates, triacrylates, tetraacrylates, dimethacrylates, trimethacrylates, and tetramethacrylates.

Examples of the polyfunctional (meth)acrylamide include diacrylamides, triacrylamides, tetraacrylamides, dimethacrylamides, trimethacrylamides, and tetramethacrylamides.

The polyfunctional (meth)acrylate may be derived from, for example, a diol, a triol, a tetraol, or a bisphenol A derivative. Specifically, thepolyfunctional (meth)acrylate maybe derivedfrom, for example, 1,10-decanediol, 1,8-octanediol, 1,6-hexanediol, 1,4-butanediol, 1,3-butanediol, 1,4-but-2-enediol, ethylene glycol, diethylene glycol, trimethylolpropane, pentaerythritol, hydroquinone, catechol, resorcinol, triethylene glycol, polyethylene glycol, sorbitol, polypropylene glycol, polytetramethylene glycol, or a propylene oxide-modified product of bisphenol A.

The polyfunctional (meth) acrylamide may be derived from, for example, its corresponding diamine, triamine, or tetraamine.

Examples of the polymerization-reactive oligomer include urethane (meth)acrylate, epoxy (meth) acrylate, copolyester (meth)acrylate, and oligomer di(meth)acrylate. Of those, hydrophobic urethane (meth)acrylate is preferred.

The weight average molecular weight of the polymerization-reactive oligomer is preferably 1,500 or more, more preferably 2,000 or more. The upper limit of the weight average molecular weight of the polymerization-reactive oligomer is not particularly limited, and is, for example, preferably 10,000 or less.

When the "one or more kinds selected from a polyfunctional (meth)acrylate, a polyfunctional (meth)acrylamide, and a polymerization-reactive oligomer each having a weight average molecular weight of 800 or more" and the "one or more kinds selected from a polyfunctional (meth)acrylate and a polyfunctional (meth)acrylamide each having a weight average molecular weight of 500 or less" are used in combination as the cross-linking agent, the lower limit value of the usage of the "one or more kinds selected from a polyfunctional (meth)acrylate, a polyfunctional (meth)acrylamide, and a polymerization-reactive oligomer each having a weight average molecular weight of 800 or more" is preferably 40 wt%, and the upper limit value thereof is preferably 100 wt%, more preferably 80 wt%, with respect to the total amount of the hydrophilic polyurethane-based polymer and the ethylenically unsaturated monomer in the continuous oil phase component. When the usage of the "one or more kinds selected from a polyfunctional (meth)acrylate, a polyfunctional (meth)acrylamide, and a polymerization-reactive oligomer each having a weight average molecular weight of 800 or more" is less than 40 wt% with respect to the total amount of the hydrophilic polyurethane-based polymer and the ethylenically unsaturated monomer in the continuous oil phase component, the cohesive strength of a heat conduction-suppressing layer to be obtained may lower, and it may become difficult to achieve both of toughness and flexibility. When the usage of the "one or more kinds selected from a polyfunctional (meth)acrylate, a polyfunctional (meth)acrylamide, and a polymerization-reactive oligomer each having a weight average molecular weight of 800 or more" is more than 100 wt% with respect to the total amount of the hydrophilic polyurethane-based polymer and the ethylenically unsaturated monomer in the continuous oil phase component, the emulsification stability of the W/O type emulsion lowers, with the result that a desired heat conduction-suppressing layer may not be obtained.

When the "one or more kinds selected from a polyfunctional (meth)acrylate, a polyfunctional (meth)acrylamide, and a polymerization-reactive oligomer each having a weight average molecular weight of 800 or more" and the "one or more kinds selected from a polyfunctional (meth)acrylate and a polyfunctional (meth)acrylamide each having a weight average molecular weight of 500 or less" are used in combination as the cross-linking agent, the lower limit value of the usage of the "one or more kinds selected from a polyfunctional (meth)acrylate and a polyfunctional (meth) acrylamide each having a weight average molecular weight of 500 or less" is preferably 1 wt%, more preferably 5 wt%, and the upper limit value thereof is preferably 30 wt%, more preferably 20 wt%, with respect to the total amount of the hydrophilic polyurethane-based polymer and the ethylenically unsaturated monomer in the continuous oil phase component. When the usage of the "one or more kinds selected from a polyfunctional (meth) acrylate and a polyfunctional (meth) acrylamide each having a weight average molecular weight of 500 or less" is less than 1 wt% with respect to the total amount of the hydrophilic polyurethane-based polymer and the ethylenically unsaturated monomer in the continuous oil phase component, heat resistance lowers, with the result that a cell structure may collapse owing to shrinkage in the step (IV) of dehydrating a water-containing polymer. When the usage of the "one or more kinds selected from a polyfunctional (meth)acrylate and a polyfunctional (meth) acrylamide each having a weight average molecular weight of 500 or less" is more than 30 wt% with respect to the total amount of the hydrophilic polyurethane-based polymer and the ethylenically unsaturated monomer in the continuous oil phase component, the toughness of a heat conduction-suppressing layer to be obtained lowers, with the result that the heat conduction-suppressing layer may exhibit brittleness.

The cross-linking agents may be used alone or in combination.

C-1-2-1-5. Other components in continuous oil phase component

The continuous oil phase component may include any appropriate other component in such a range that the effects of the present invention are not impaired. Typical preferred examples of such other component include a catalyst, an antioxidant, a light stabilizing agent, and an organic solvent. Such other components may be used alone or in combination.

Examples of the catalyst include a urethane reaction catalyst. Any appropriate catalyst may be adopted as the urethane reaction catalyst. Specific examples thereof include dibutyltin dilaurate.

Any appropriate content may be adopted as the content of the catalyst depending on a catalytic reaction of interest.

The catalysts may be used alone or in combination.

Examples of the antioxidant include a phenol-based antioxidant, a thioether-based antioxidant, and a phosphorus-based antioxidant.

Any appropriate content may be adopted as the content of the antioxidant in such a range that the effects of the present invention are not impaired.

The antioxidants may be used alone or in combination.

C-2. Step (II) of forming W/O type emulsion into shape

In the step (II), any appropriate shape formation method may be adopted as the method of forming the W/O type emulsion into a shape. For example, there is given a method involving continuously supplying the W/O type emulsion on a moving belt and forming the emulsion into a flat sheet shape on the belt. Further, there is given a method involving applying the W/O type emulsion onto one surface of a thermoplastic resin film to form the emulsion into a shape.

In the step (II), when the method involving applying the W/O type emulsion onto one surface of a thermoplastic resin film to form the emulsion into a shape is adopted as the method of forming the W/O type emulsion into a shape, the application method is, for example, a method using a roll coater, a die coater, or a knife coater.

C-3. Step (III) of polymerizing W/O type emulsion formed into shape

In the step (III), any appropriate polymerization method may be adopted as the method of polymerizing the W/O type emulsion formed into a shape. For example, there are given: a method involving continuously supplying the W/O type emulsion onto a moving belt having a structure in which a belt surface of a belt conveyor is warmed with a heating apparatus and polymerizing the emulsion by heating while forming the emulsion into a flat sheet shape on the belt; and a method involving continuously supplying the W/O type emulsion onto a moving belt having a structure in which a belt surface of a belt conveyor is warmed by irradiation with active energy rays and polymerizing the emulsion by irradiation with active energy rays while forming the emulsion into a flat sheet shape on the belt.

When the polymerization is performed by heating, the lower limit value of a polymerization temperature (heating temperature) is preferably 23°C, more preferably 50°C, still more preferably 70°C, particularly preferably 80°C, most preferably 90°C, and the upper limit value thereof is preferably 150°C, more preferably 130°C, still more preferably 110°C. When the polymerization temperature is less than 23°C, it takes a long time to perform the polymerization, with the result that industrial productivity may lower. When the polymerization temperature is more than 150°C, the pore diameters of a heat conduction-suppressing layer to be obtained may become non-uniform, and the strength of the heat conduction-suppressing layer may lower. It should be noted that the polymerization temperature does not need to be kept constant, and for example, may be changed in two stages or a plurality of stages during the polymerization.

When the polymerization is performed by irradiation with active energy rays, examples of the active energy rays include UV light, visible light, and electron beams. The active energy rays are preferably UV light and visible light, more preferably visible to UV light having a wavelength of 200 nm to 800 nm. The W/O type emulsion has a strong tendency to scatter light. Hence, when the visible to UV light having a wavelength of 200 nm to 800 nm is used, the light can pass through the W/O type emulsion. Further, a photopolymerization initiator which can be activated by the light having a wavelength of 200 nm to 800 nm is easily available, and a source for the light is also easily available.

The lower limit value of the wavelength of the active energy rays is preferably 200 nm, more preferably 300 nm, and the upper limit value thereof is preferably 800 nm, more preferably 450 nm.

As a typical apparatus to be used in the irradiation with active energy rays, for example, there is given an apparatus having a spectrum distribution in a region having a wavelength of 300 to 400 nm as a UV lamp which can perform irradiation with UV light. Examples thereof include a chemical lamp, a Black Light lamp (manufactured by TOSHIBA LIGHTING & TECHNOLOGY CORPORATION, trade name), and a metal halide lamp.

An illuminance upon the irradiation with active energy rays may be set to any appropriate illuminance by regulating a distance from an irradiation apparatus to an object to be irradiated and a voltage. For example, according to the method disclosed in JP 2003-13015 A, irradiation with UV light in each step can be performed in a plurality of divided stages, thereby precisely regulating pressure-sensitive adhesion performance.

In order to prevent oxygen having a polymerization-inhibiting action from causing an adverse influence, for example, the irradiation with UV light is preferably performed under an inert gas atmosphere after a W/O type emulsion has been applied onto one surface of a substrate such as a thermoplastic resin film and formed into a shape, or by covering with a film which transmits UV light but blocks oxygen, e.g., polyethylene terephthalate coated with a releasing agent such as silicone, after a W/O type emulsion has been applied onto one surface of a substrate such as a thermoplastic resin film and formed into a shape.

Any appropriate thermoplastic resin film may be adopted as the thermoplastic resin film as long as the W/O type emulsion can be applied onto one surface of the film and formed into a shape. Examples of the thermoplastic resin film include plastic films and sheets made of polyester, an olefin-based resin, and polyvinyl chloride. Further, such plastic films and sheets may have one side or both sides thereof subjected to releasing treatment.

The inert gas atmosphere refers to an atmosphere in which oxygen in a photoirradiation zone has been replaced by inert gas. Accordingly, the amount of oxygen present in the inert gas atmosphere needs to be as small as possible, and is preferably 5,000 ppm or less in terms of oxygen concentration.

C-4. Step (IV) of dehydrating resultant water-containing polymer

In the step (IV), the resultant water-containing polymer is dehydrated. An aqueous phase component is present in a dispersed state in the water-containing polymer obtained in the step (III). A porous material is obtained by removing the aqueous phase component through dehydration, followed by drying. The porous material can serve as the heat conduction-suppressing layer without any treatment. Further, the porous material can serve as the heat conduction-suppressing layer by being used in combination with any appropriate substrate.

Any appropriate drying method may be adopted as the dehydration method in the step (IV). Examples of such drying method include vacuum drying, freeze drying, press drying, drying in a microwave oven, drying in a heat oven, drying with infrared rays, and combinations of these technologies.

D. Heat conductive layer

In the radiant heat conduction-suppressing sheet according to the embodiment of the present invention, the far-infrared absorptivity of the heat conductive layer is set small. With this, radiant heat conduction from the heating element can be suppressed, and a temperature increase in the heating element due to heat transfer from the heating element by convection can be suppressed. In addition, a temperature increase and heat spot on the surface of the housing can be suppressed by heat diffusion in the heat conductive layer in its plane direction.

Examples of the heat conductive layer include a graphite sheet and a metal foil. A material for the metal foil is exemplified by aluminum, gold, silver, and copper. An aluminum foil and a copper foil each having a high far-infrared reflectance and being inexpensive in terms of process cost are preferred.

The far-infrared absorptivity of the heat conductive layer is calculated through use of Equation 1 based on its transmittance and reflectance at a wavelength of 7 $\mu$m to 10 $\mu$m measured by employing FT-IR. The far-infrared absorptivity of the heat conductive layer at a wavelength of 7 $\mu$m to 10 $\mu$m is 0.6 or less, preferably 0.4 or less, more preferably 0.3 or less. When the far-infrared absorptivity of the heat conductive layer at a wavelength of 7 $\mu$m to 10 $\mu$m is more than 0.6, far-infrared rays emitted from a heating element are absorbed by the heat conductive layer as well to be converted into heat which rapidly undergoes solid heat conduction into the surrounding environment, and hence a heat spot may occur on the surface of the housing. Further, the far-infrared rays emitted from the heating element may be transmitted through the heat conductive layer and the transmitted far-infrared rays may be absorbed by the housing to increase the temperature of the surface of the housing.

```
Far-infrared          absorptivity=1-(transmittance       +

reflectance)/100  ··· Equation 1
```

The heat conductive layer has a far-infrared reflectance at a wavelength of 7 $\mu$m to 10 $\mu$m of preferably 0.4 or more, more preferably 0.5 or more, still more preferably 0.7 or more. When the far-infrared reflectance of the heat conductive layer is less than 0.4, far-infrared reflection at the heat conductive layer may not occur sufficiently and far-infrared rays may be absorbed or transmitted to increase the temperature of the surface of the housing. It should be noted that the far-infrared reflectance of the heat conductive layer may be determined by reflectance measurement employing FT-IR.

The heat conductivity of the heat conductive layer as measured by a steady-state method is 200 W/m·K or more, preferably 300 W/m·K or more, more preferably 400 W/m·K or more. When the heat conductivity is less than 200 W/m·K, solid heat conductivity from the heat conduction-suppressing layer reduces, and hence far-infrared rays emitted from a heating element may not be efficiently absorbed by the heat conduction-suppressing layer, with the result that a temperature increase in the heating element may not be suppressed. It should be noted that a practical upper limit of the heat conductivity is, for example, 1,500 W/m·K.

The thickness of the heat conductive layer may be adjusted to any appropriate thickness depending on purposes. The thickness of the heat conductive layer is preferably 0.03 mm or more, more preferably 0.05 mm or more, still more preferably 0.1 mm or more, particularly preferably 0.15 mm or more. When the thickness of the heat conductive layer is less than 0.03 mm, heat diffusion property in the heat conductive layer in its plane direction is liable to reduce, and a suppressive effect on the occurrence of a heat spot on the surface of a housing may reduce.

The area of the heat conductive layer may be adjusted to any appropriate area depending on purposes. When the radiant heat conduction-suppressing sheet is used by being fixed to a housing containing a heating element under a state in which the side of the heat conduction-suppressing layer is fixed to the housing at such a position that the heat conductive layer faces the heat radiating surface of the heating element while being free of close contact with the heating element, the area of the heat conductive layer is preferably 4 or more times, more preferably 7 or more times, still more preferably 10 or more times as large as the area of the heat radiating surface of the heating element. With such construction, heat generated from the heating element can be efficiently diffused through the heat conductive layer in its plane direction, and the heat diffused through the heat conductive layer is gradually conducted to the surface of the housing through the heat conduction-suppressing layer. Thus, a local temperature increase on the surface of the housing can be prevented.

E. Pressure-sensitive adhesive layer

A pressure-sensitive adhesive layer formed of any appropriate pressure-sensitive adhesive may be adopted as the pressure-sensitive adhesive layer. Specific examples of the pressure-sensitive adhesive to be used include an acrylic pressure-sensitive adhesive, an epoxy-based pressure-sensitive adhesive, and a silicone-based pressure-sensitive adhesive.

The thickness of the pressure-sensitive adhesive layer is preferably 0.01 mm to 0.05 mm, more preferably 0.01 mm to 0.03 mm. When the thickness of the pressure-sensitive adhesive layer is less than 0.01 mm, followability for a pressure-sensitive adhesive surface is poor. When peeling occurs owing to the poor followability, solid heat conductivity reduces in many cases. On the other hand, when the thickness of the pressure-sensitive adhesive layer is more than 0.1 mm, it may be difficult to introduce the radiant heat conduction-suppressing sheet into electronic devices whose thicknesses are being made smaller and smaller under a non-contact condition.

F. Adhesion layer

An adhesion layer formed of any appropriate adhesive may be adopted as the adhesion layer. Specific examples of the adhesive to be used include an acrylic adhesive, an epoxy-based adhesive, and a silicone-based adhesive.

The thickness of the adhesion layer is preferably 0.01 mm to 0.05 mm, more preferably 0.01 mm to 0.03 mm. When the thickness of the adhesion layer is less than 0.01 mm, followability for an adhesion surface is poor. When peeling occurs owing to the poor followability, solid heat conductivity reduces in many cases. On the other hand, when the thickness of the adhesion layer is more than 0.1 mm, it may be difficult to introduce the radiant heat conduction-suppressing sheet into electronic devices whose thicknesses are being made smaller and smaller under a non-contact condition.

G. Applications of radiant heat conduction-suppressing sheet

The radiant heat conduction-suppressing sheet according to the embodiment of the present invention is used by being fixed to a housing containing a heating element under a state in which the side of the heat conductive suppressing layer is fixed to the housing at such a position that the heat conductive layer faces the heat radiating surface of the heating element while being free of close contact with the heating element. In the housing with the radiant heat conduction-suppressing sheet thus obtained, a temperature increase in the heating element is suppressed, a heat spot hardly occurs on the surface of the housing, and a temperature increase on the surface of the housing is also suppressed. In addition, the radiant heat conduction-suppressing sheet according to the embodiment of the present invention includes the heat conduction-suppressing layer having very excellent pressure-sensitive adhesive property, and hence can be mounted onto a housing by an extremely easy operation and is excellent in adhesiveness for the housing.

Examples

(Measurement of molecular weight)

A weight average molecular weight was determined by gel permeation chromatography (GPC).
Apparatus: "HLC-8020" manufactured by Tosoh Corporation
Column: "TSKgel GMH$_{HR}$-H(20)" manufactured by Tosoh Corporation
Solvent: Tetrahydrofuran
Standard substance: Polystyrene

(Measurement of average pore diameter)

A porous material obtained in Examples was cut in its thickness direction with amicrotome cutter to prepare a sample for measurement. Images of the cut surface of the sample for measurement were taken at magnifications of 800 to 5, 000 with a low-vacuum scanning electron microscope (manufactured by Hitachi, Ltd., S-3400N). Through use of the resultant images, the long axis lengths of about 30 largest pores were measured for each of spherical cells, through-holes, and surface openings in any appropriate range, and an average of the measured values was defined as an average pore diameter.

(Measurement of far-infrared transmittance and far-infrared reflectance, and calculation of far-infrared absorptivity)

Heat conduction-suppressing layers (porous materials) obtained in Examples were each measured for a far-infrared transmittance and far-infrared reflectance at a wavelength of 7 μm to 10 μm. Specifically, the reflectance and transmittance were measured with an FT-IR apparatus "Spectrum One" manufactured by PerkinElmer Japan Co., Ltd. The measurement of the reflectance was performed by a reflection method involving using a gold mirror as a reference and using an apparatus "10 Degree Specular Reflectance Accessory" manufactured by PIKE TECHNOLOGIES as a reflection accessory. The measurement was performed twice for each sample for measurement under the conditions of a resolution of 4 cm$^{-1}$ and a cumulative number of 16, and an average of the measured values was determined.
A far-infrared absorptivity was calculated by Equation 1 based on the resultant reflectance and transmittance.

```
Far-infrared          absorptivity=1-(transmittance       +

reflectance)/100  ··· Equation 1
```

(Measurement of heat conductivity)

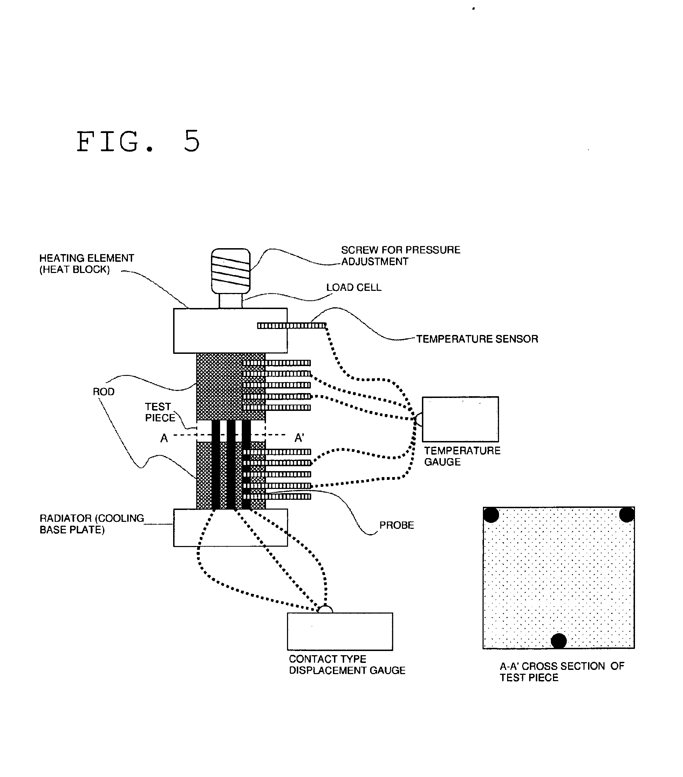

A heat conductivity was measured with a measurement apparatus illustrated in FIG. 5.

(i) Construction of measurement apparatus

A test piece (20 mm by 20 mm) is sandwiched between a pair of rods L made of aluminum (A5052, a heat conductivity: 140 W/m·K) formed so as to be a cube with a side length of 20 mm. Next, the pair of rods is disposed between a heating element (heater block) H and a radiator (cooling base plate constructed so as to circulate cooling water therethrough) C so as to be arranged on the upper and lowersides. Morespecifically, the heating element H is disposed on the rod L on the upper side, and the radiator C is disposed beneath the rod L on the lower side.

In this case, the pair of rods L is positioned between a pair of screws for pressure adjustment T penetrating the heating element and the radiator. It should be noted that a load cell R is disposed between the screw for pressure adjustment T on the upper side and the heating element H, and is constructed so as to measure a pressure in tightening the screws for pressure adjustment T. Such pressure is defined as a pressure to be applied to the test piece.

In addition, three probes P (diameter: 1 mm) of a contact type displacement gauge are installed so as to penetrate the rod L on the lower side and the test piece from the radiator C side. In this case, each of the upper end portions of the probes P is in contact with the lower surface of the rod L on the upper side, and is constructed so that an interval between the rods L on the upper and lower sides (thickness of the test piece) can be measured.

Temperature sensors D are attached to the heating element H and the rods L on the upper and lower sides. Specifically, the temperature sensors D are attached to one site of the heating element H and five sites at an interval of 5 mm in the vertical direction of each of the rods L.

(ii) Measurement

In the measurement, first, a pressure was applied to the test piece by tightening the screws for pressure adjustment T, the temperature of the heating element H was set to 80°C, and cooling water at 20°C was circulated through the radiator C.

Next, after the temperatures of the heating element H and the rods L on the upper and lower sides had become stable, the temperatures of the rods L on the upper and lower sides were measured with the respective temperature sensors D, a heat flux passing through the test piece was calculated based on the heat conductivity and temperature gradient of the rods L on the upper and lower sides, and temperatures at the interfaces between the rods L on the upper and lower sides and the test piece were calculated. Through use of those values, a heat conductivity (W/m·K) at the compression rate was calculated.

(Evaluation of radiant heat conduction suppressive effect)

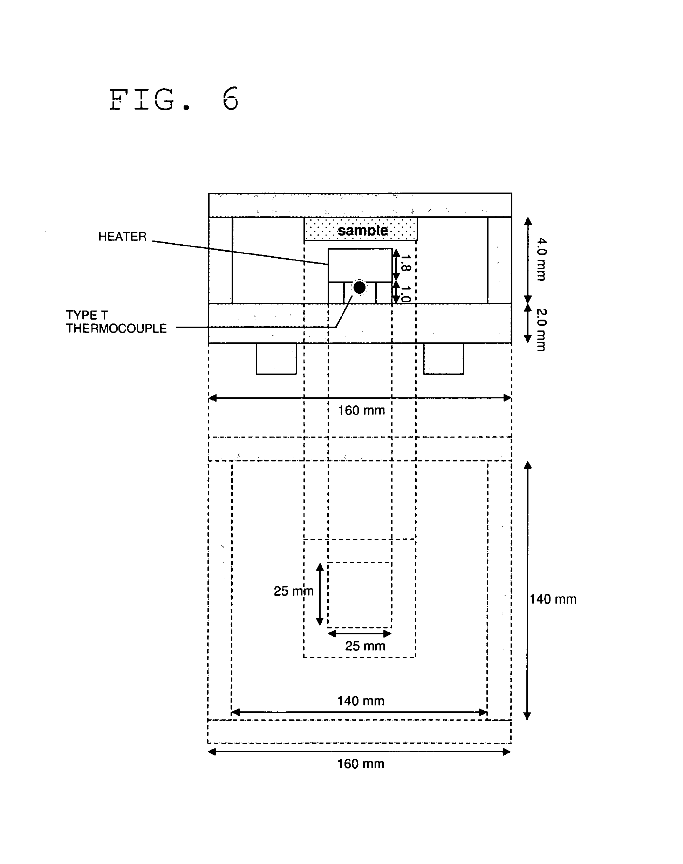

As illustrated in FIG. **6**, a ceramic heater (25 mm square) provided with a thermocouple was mounted on a stage formed of a polycarbonate (PC) plate having a thickness of 2 mm, and the power was set to 1.18 W. Each of the radiant heat conduction-suppressing sheets obtained in Examples was cut into a piece having a size of 70 mm square, which was used as a heat conductive test piece and was mounted onto the stage by fixing the side of the heat conduction-suppressing layer to the PC plate (160 mm by 160 mm by 2 mm) serving as a housing at such a position that the heat conductive layer faced the heat radiating surface of the heat-generating part while being free of close contact with the heat-generating part.

The temperature of the ceramic heater was measured with the thermocouple, and the temperature of the surface of the housing was measured with Thermography (manufactured by NEC Avio Infrared Technologies Co. Ltd., TYPE H2640). The temperatures of both in steady states were defined as the temperature of the heating element and the temperature of the surface of the housing, respectively.

(Measurement of shear adhesive strength)

Each of the obtained porous materials was cut into pieces each having a size of 25 mm by 25 mm, and an aluminum plate and a PC plate were attached to both surfaces of the porous material of each piece, respectively, to prepare samples for measurement. Crimping was performed by reciprocating once a 2-kg roller on the samples for measurement in a horizontal attitude. After the crimping, each of the samples for measurement was left to stand under a normal temperature, 80°C, or 0° C atmosphere for 30 minutes, fixed to Tensilon under each temperature environment so as to be perpendicular, pulled at a tensile speed of 50 mm/min, and measured for its shear adhesive strength in the middle of the pulling. The number of the samples measured was n=3, and an average of the measured values was defined as a shear adhesive strength under each temperature atmosphere.

(Measurement of attachment storage stability)

Each of the obtained porous materials was cut, and an aluminum foil (manufactured by The Nilaco Corporation, AL-013351, thickness; 100 $\mu$m) was directly attached onto one surface of the porous material, and the resultant was cut into a piece having a size of 70 mm by 70 mm. After that, the other surface was attached to a PC plate to prepare a sample for measurement. Crimping was performed by reciprocating once a 2-kg roller on the sample for measurement in a horizontal attitude. After the crimping, the test piece was mounted onto a holder so as to be perpendicular, and left to stand at under a normal temperature, 80°C, 60°C/90%RH, or -40°C atmosphere for 240 hours. The floating and peeling state of the aluminum foil which had been left to stand for 240 hours was observed for the following four-stage evaluation: ◎; no peeling or floating was present, ○; slight floating was present, △; partial peeling was present, x; floating or peeling corresponding to 40% or more of the attachment area was present.

(Production Example 1): Preparation of mixed syrup 1

A reactor equipped with a cooling tube, a temperature gauge, and a stirrer was fed with 173.2 parts by weight of a monomer solution formed of 2-ethylhexyl acrylate (manufactured by TOAGOSEI CO., LTD., hereinafter abbreviated as "2EHA") as an ethylenically unsaturated monomer, 100 parts by weight of ADEKA (trademark) Pluronic L-62 (molecular weight: 2,500, manufactured by ADEKA CORPORATION, polyether polyol) as polyoxyethylene polyoxypropylene glycol, and 0.014 part by weight of dibutyltin dilaurate (manufactured by KISHIDA CHEMICAL Co. , Ltd., hereinafter abbreviated as "DBTL") as a urethane reaction catalyst. To the stirred mixture were added dropwise 12.4 parts by weight of hydrogenated xylylene diisocyanate (manufactured by Takeda Pharmaceutical Co., Ltd., TAKENATE 600, hereinafter abbreviated as "HXDI"), and the resultant mixture was subjected to a reaction at 65°C for 4 hours. It should be noted that the usage of a polyisocyanate component and a polyol component in terms of NCO/OH (equivalent ratio) was 1.6. After that, 5. 6 parts by weight of 2-hydroxyethyl acrylate (manufactured by KISHIDA CHEMICAL Co., Ltd., hereinafter abbreviated as "HEA") were added dropwise, and the mixture was subjected to a reaction at 65°C for 2 hours. Thus, a hydrophilic polyurethane-based polymer/ethylenically unsaturated monomer mixed syrup was obtained. The resultant hydrophilic polyurethane-based polymer had a weight average molecular weight of 15,000. To 100 parts by weight of the resultant hydrophilic polyurethane-based polymer/ethylenically unsaturated monomer mixed syrup were added 27.3 parts by weight of 2EHA, 51.8 parts by weight of n-butyl acrylate (manufactured by TOAGOSEI CO. , LTD., hereinafter abbreviated as "BA"), 17.6 parts by weight of isobornyl acrylate (e.g., manufactured by Osaka Organic Chemical Industry Ltd., hereinafter abbreviated as "IBXA"), and 10.5 parts by weight of acrylic acid (manufactured by TOAGOSEI CO., LTD., hereinafter abbreviated as "AA") as a polar monomer. Thus, a hydrophilic polyurethane-based polymer/ethylenically unsaturated monomer mixed syrup 1 was obtained.

(Production Example 2): Preparation of mixed syrup 2

A reactor equipped with a cooling tube, a temperature gauge, and a stirrer was fed with 173.2 parts by weight of a monomer solution formed of IBXA as an ethylenically unsaturated monomer, 100 parts by weight of ADEKA (trademark) Pluronic L-62 (molecular weight: 2,500, manufactured by ADEKA CORPORATION, polyether polyol) as polyoxyethylene polyoxypropylene glycol, and 0.014 part by weight of DBTL as a urethane reaction catalyst. To the stirred mixture were added dropwise 12.4 parts by weight of HXDI, and the resultant mixture was subjected to a reaction at 65°C for 4 hours. It should be noted that the usage of a polyisocyanate component and a polyol component in terms of NCO/OH (equivalent ratio) was 1.6. After that, 5.6 parts by weight of HEA were added dropwise, and the mixture was subjected to a reaction at 65°C for 2 hours. Thus, a hydrophilic polyurethane-based polymer/ethylenically unsaturated monomer mixed syrup was obtained. The resultant hydrophilic polyurethane-based polymer had a weight average molecular weight of 15,000. To 100 parts by weight of the resultant hydrophilic polyurethane-based polymer/ethylenically unsaturated monomer mixed syrup were added 24.7 parts by weight of 2EHA, 69.3 parts by weight of IBXA, and 10.5 parts by weight of AA as a polar monomer. Thus, a hydrophilic polyurethane-based polymer/ethylenically unsaturated monomer mixed syrup 2 was obtained.

(Example 1)

100 Parts by weight of the hydrophilic polyurethane-based polymer/ethylenically unsaturated monomer mixed syrup 1 obtained in Production Example 1 were homogeneously mixed with 11.9 parts by weight of 1,6-hexanediol diacrylate (a product available under the trade name "NK Ester A-HD-N" from Shin Nakamura Chemical Co., Ltd.) (molecular weight: 226), 47.7 parts by weight of urethane acrylate (hereinafter abbreviated as "UA") (molecular weight : 3,720) having an ethylenically unsaturated group at each of both terminals, in which both terminals of polyurethane synthesized from polytetramethylene glycol (hereinafter abbreviated as "PTMG") and isophorone diisocyanate (hereinafter abbreviated as "IPDI") were treated with HEA, as a reactive oligomer, 0.48 part by weight of diphenyl(2,4,6-trimethylbenzoyl)phosphine oxide (a product available under the trade name "Lucirin TPO" from BASF), 0. 95 part by weight of a hindered phenol-based ant ioxidant (a product available under the trade name "Irganox 1010" from Ciba Japan), and 2 parts by weight of a light stabilizing agent (e.g. , a product available under the trade name "TINUVIN123" from BASF). Thus, a continuous oil phase component (hereinafter referred to as "oil phase") was obtained. Meanwhile, 300 parts by weight of ion-exchanged water as an aqueous phase component (hereinafter referred to as "aqueous phase") with respect to 100 parts by weight of the oil phase were continuously supplied dropwise at normal temperature into a stirring/mixing machine as an emulsifying machine fed with the oil phase. Thus, a stable W/O type emulsion was prepared. It should be noted that the emulsion had the aqueous phase and the oil phase at a weight ratio of 75/25.

The resultant W/O type emulsion was statically stored at normal temperature for 1 hour, and was then applied onto a substrate subj ected to releasing treatment, so as to have a thickness of 0.2 mm after photoirradiation, and continuously formed into a shape. The top of the resultant was further covered with a polyethylene terephthalate film subjected to releasing treatment and having a thickness of 38 $\mu$m. The sheet was irradiated with UV light at a light illuminance of 5 mW/cm$^2$ (measured with TOPCON UVR-T1 at maximum peak sensitivity wavelength of 350 nm) through use of a Black Light lamp (15 W/cm). Thus, a high-water-content cross-linked polymer having a thickness of 0.2 mm was obtained. Next, the upper surface film was peeled off, and the high-water-content cross-linked polymer was heated at 140°C over 3 minutes. Thus, a heat conduction-suppressing layer 1 having a thickness of 0.2 mm and a cell content of about 75% was obtained.

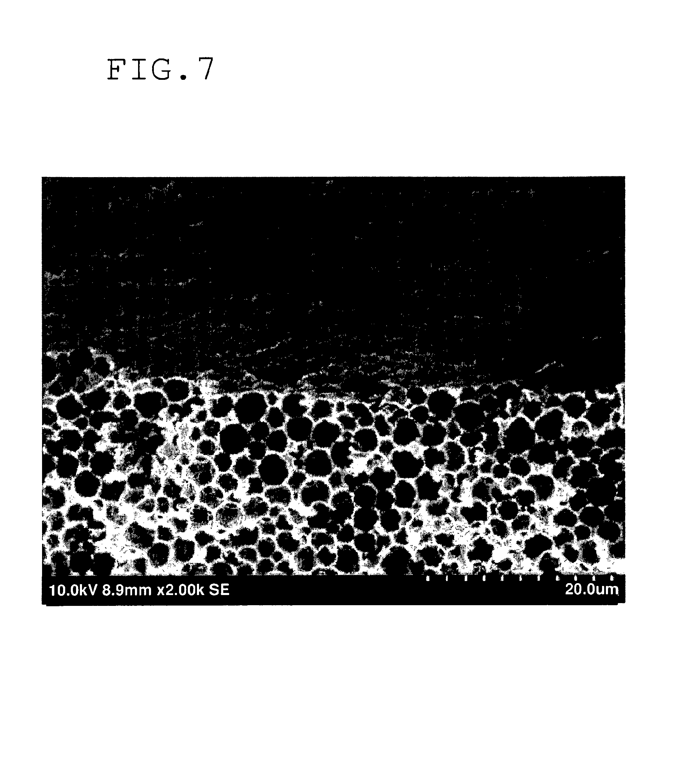

The resultant heat conduction-suppressing layer 1 had a heat conductivity in the thickness direction of 0.054 W/m·K. FIG. 7 shows a photographic view of a surface/cross-sectional SEM photograph of the resultant heat conduction-suppressing layer 1 taken from an oblique direction.

Next, a thin-film double coated tape (manufactured by NITTO DENKO CORPORATION, No. 5601) having a total thickness of 10 $\mu$m was attached to each of both surfaces of the heat conduction-suppressing layer 1, and an aluminum foil (manufactured by Toyo Aluminium K. K. , thickness; 80 $\mu$m) as a heat conductive layer was further laminated on one pressure-sensitive adhesive layer to produce a radiant heat conduction-suppressing sheet 1 having a total thickness of about 0.3 mm. The resultant radiant heat conduction-suppressing sheet 1 was subjected to the evaluation of a radiant heat conduction suppressive effect, and the maximum value of the temperature of the surface of the housing and the maximum value of the temperature of the heating element were observed. Table 1 shows the results.

(Example 2)

100 Parts by weight of the hydrophilic polyurethane-based polymer/ethylenically unsaturated monomer mixed syrup 2 obtained in Production Example 2 were homogeneously mixed with 15.9 parts by weight of 1,6-hexanediol diacrylate, 47.7 parts by weight of UA (molecular weight: 3,720) having an ethylenically unsaturated group at each of both terminals, in which both terminals of polyurethane synthesized from PTMG and IPDI were treated with HEA, as a reactive oligomer, 0.48 part by weight of diphenyl(2,4,6-trimethylbenzoyl)phosphine oxide (a product available under the trade name "Lucirin TPO" from BASF), 0. 95 part by weight of a hindered phenol-based antioxidant (a product available under the trade name "Irganox 1010" from Ciba Japan), and 2 parts by weight of a light stabilizing agent (a product available under the trade name "TINUVIN123" from BASF). Thus, a continuous oil phase component (hereinafter referred to as "oil phase") was obtained. Meanwhile, 300 parts by weight of ion-exchanged water as an aqueous phase component (hereinafter referred to as "aqueous phase") with respect to 100 parts by weight of the oil phase were continuously supplied dropwise at normal temperature into a stirring/mixing machine as an emulsifying machine fed with the oil phase. Thus, a stable W/O type emulsion was prepared. It should be noted that the emulsion had the aqueous phase and the oil phase at a weight ratio of 75/25.

The resultant W/O type emulsion was statically stored at normal temperature for 1 hour, and was then applied onto a substrate subjected to releasing treatment, so as to have a thickness of 0.2 mm after photoirradiation, and continuously formed into a shape. The top of the resultant was further covered with a polyethylene terephthalate film subjected to releasing treatment and having a thickness of 38 $\mu$m. The sheet was irradiated with UV light at a light illuminance of 5 mW/cm$^2$ (measured with TOPCON UVR-TI at a maximum peak sensitivity wavelength of 350 nm) through use of a Black Light lamp (15 W/cm). Thus, a high-water-content cross-linked polymer having a thickness of 0.2 mm was obtained. Next, the upper surface filmwaspeeledoff, and the high-water-content cross-linked polymer was heated at 140°C over 3 minutes. Thus, a heat conduction-suppressing layer 2 having a thickness of 0.2 mm and a cell content of about 75% was obtained. The resultant heat conduction-suppressing layer 2 had a heat conductivity in the thickness direction of 0.048 W/m·K.

Next, a thin-film double coated tape (manufactured by NITTO DENKO CORPORATION, No. 5601) having a total thickness of 10 $\mu$m was attached to each of both surfaces of the heat conduction-suppressing layer 2, and an aluminum foil (manufactured by Toyo Aluminium K.K., thickness; 80 $\mu$m) as a heat conductive layer was further laminated on one pressure-sensitive adhesive layer to produce a radiant heat conduction-suppressing sheet 2 having a total thickness of about 0.3 mm. The resultant radiant heat conduction-suppressing sheet 2 was subjected to the evaluation of a radiant heat conduction suppressive effect, and the maximum value of the temperature of the surface of the housing and the maximum value of the temperature of the heating element were observed. Table 1 shows the results.

(Example 3)

The heat conduction-suppressing layer 1 obtained in Example 1 and an aluminum foil (manufactured by Toyo Aluminium K.K., thickness; 80 μm) as a heat conductive layer were directly laminated to produce a radiant heat conduction-suppressing sheet 3 having a total thickness of about 0.28 mm. The resultant radiant heat conduction-suppressing sheet 3 was subjected to the evaluation of a radiant heat conduction suppressive effect, and the maximum value of the temperature of the surface of the housing and the maximum value of the temperature of the heating element were observed. Table 1 shows the results. In addition, Table 2 shows the evaluation results of the adhesiveness (attachment storage stability) of the heat conduction-suppressing layer 1.

(Example 4)

A heat conduction-suppressing layer 3 having a cell content of about 75% was produced in the same manner as in Example 1 except that the thickness was changed to 0.05 mm. The resultant heat conduction-suppressing layer 3 had a heat conductivity in the thickness direction of 0.05 W/m·K. The resultant heat conduction-suppressing layer 3 and an aluminum foil (manufactured by Toyo Aluminium K. K. , thickness; 80 μm) as a heat conductive layer were directly laminated to produce a radiant heat conduction-suppressing sheet 4 having a total thickness of about 0.13 mm. The resultant radiant heat conduction-suppressing sheet 4 was subjected to the evaluation of a radiant heat conduction suppressive effect, and the maximum value of the temperature of the surface of the housing and the maximum value of the temperature of the heating element were observed. Table 1 shows the results. In addition, Table 2 shows the evaluation results of the adhesiveness (attachment storage stability) of the heat conduction-suppressing layer 3.

(Example 5)

A radiant heat conduction-suppressing sheet 5 having a total thickness of about 0.175 mm was produced in the same manner as in Example 4 except that an aluminum foil (manufactured by The Nilaco Corporation, AL-013351, thickness; 125 μm) was used as the heat conductive layer. The resultant radiant heat conduction-suppressing sheet 5 was subjected to the evaluation of a radiant heat conduction suppressive effect, and the maximum value of the temperature of the surface of the housing and the maximum value of the temperature of the heating element were observed. Table 1 shows the results.

(Comparative Example 1)

The heat conductive test piece was subjected to the evaluation of a radiant heat conduction suppressive effect as a blank sample without being fixed to the PC plate serving as the housing. Table 1 shows the results.

Table 1

| | | | Example 1 | Example 2 | Example 3 | Example 4 | Example 5 | Comparative Example 1 |
|---|---|---|---|---|---|---|---|---|
| Construction | Pressure-sensitive adhesive layer | Construction Layer thickness (mm) | No. 5601<br>0.01 | No. 5601<br>0.01 | Absent<br>- | Absent<br>- | Absent<br>- | Absent<br>- |
| | Heat conduction-sup pressing layer | Construction Layer thickness (mm) | 1<br>0.2 | 2<br>0.2 | 1<br>0.2 | 3<br>0.05 | 3<br>0.05 | Absent<br>- |
| | Pressure-sensitive adhesive layer | Construction Layer thickness (mm) | No. 5601<br>0.01 | No. 5601<br>0.01 | Absent<br>- | Absent<br>- | Absent<br>- | Absent<br>- |
| | Heat conductive layer | Construction Layerthickness (mm) | Aluminum foil<br>0.08 | Aluminum foil<br>0.08 | Aluminum foil<br>0.08 | Aluminum foil<br>0.08 | Aluminum foil<br>0.125 | Absent<br>- |
| Heat conduction suppressive effect | Housingsurface temperature | [°C] | 38.3 | 38.3 | 37.5 | 37.1 | 36.4 | 59.9 |
| | Heating element temperature | [°C] | 67.7 | 67.8 | 69.0 | 71.0 | 69.9 | 77.3 |
| *Housing surface temperature; a maximum value is shown. | | | | | | | | |

Table 2

| | | | Heat conduction-suppressing layer 1 | Heat conduction-suppressing layer 3 |
|---|---|---|---|---|
| Structure | Thickness | (mm) | 0.2 | 0.05 |
| | Average surface opening diameter | ($\mu$m) | 2.2 | 2.1 |
| | Average spherical cell diameter | ($\mu$m) | 3.4 | 3.3 |
| | Average through-hole diameter | ($\mu$m) | 1.2 | 1.0 |
| | Cell content | (%) | 75 | 75 |
| Fixability | Shear adhesive strength at normal temperature | (N/cm$^2$) | 61.2 | 68.9 |
| | Shear adhesive strength at 80°C | (N/cm$^2$) | 20.2 | 42.1 |
| | Shear adhesive strength at 0°C | (N/cm$^2$) | 114.4 | 119.3 |
| | Attachment storage stability at normal temperature | - | ◎ | ◎ |
| | Attachment storage stability at 80°C | - | ◎ | ◎ |
| | Attachment storage stability at 60°C/90%RH | - | ◎ | ◎ |
| | Attachment storage stability at -40°C | - | ◎ | ◎ |

As apparent from Table 1, it was confirmed that, as compared to Comparative Example using no radiant heat conduction-suppressing sheet, the introduction of the radiant heat conduction-suppressing sheet of each of Examples suppressed a temperature increase and the occurrence of a heat spot on the surface of the housing, and suppressed a temperature increase in the heating element. Further, as apparent from Table 2, it was confirmed that, when the heat conduction-suppressing layer of the radiant heat conduction-suppressing sheet of Example was obtained by forming an W/O type emulsion into a shape and polymerizing the emulsion, sufficient adhesiveness for each adherend was obtained without providing an adhesion layer or a pressure-sensitive adhesive layer.

The radiant heat conduction-suppressing sheet of the present invention can be used, for example, by being bonded to a product housing or the like for enclosing heating elements such as electronic parts to be mounted on an electronic device or the like. A part onto which the sheet is mounted is exemplified by portions, which require heat shielding, of: electronic devices such as a personal computer, a tablet PC, a PDA, a mobile phone, and a digital camera; information devices such as a printer, a copier, and a projector; and electrical appliances for cooking such as a hot water dispenser, a microwave oven, and a water heater.

Many other modifications will be apparent to and be readily practiced by those skilled in the art without departing from the scope and spirit of the invention. It should therefore be understood that the scope of the appended claims is not intended to be limited by the details of the description but should rather be broadly construed.

**Claims**

1. A radiant heat conduction-suppressing sheet, comprising:

    a heat conduction-suppressing layer; and
    a heat conductive layer,
    wherein:

        the heat conduction-suppressing layer has a heat conductivity of 0.06 W/m·K or less;

the heat conductive layer has
a far-infrared absorptivity at a wavelength of 7 $\mu$m to 10 $\mu$m of 0.6 or less, and
a heat conductivity of 200 W/m·K or more; and
the radiant heat conduction-suppressing sheet is used by being fixed to a housing containing a heating element under a state in which a side of the heat conduction-suppressing layer is fixed to the housing at such a position that the heat conductive layer faces a heat radiating surface of the heating element while being free of close contact with the heating element.

2.  A radiant heat conduction-suppressing sheet according to claim 1, wherein the heat conduction-suppressing layer comprises a porous material including spherical cells each having an average pore diameter of 100 $\mu$m or less.

3.  A radiant heat conduction-suppressing sheet according to claim 2, wherein the heat conduction-suppressing layer comprises  a porous material having surface openings.

4.  A radiant heat conduction-suppressing sheet according to claim 2 or 3 , wherein the heat conduction-suppressing layer comprises a porous material including: spherical cells each having an average pore diameter of less than 20 $\mu$m; and through-holes between adjacent spherical cells.

5.  A radiant heat conduction-suppressing sheet according to any one of claims 1 to 4, wherein the heat conduction-suppressing layer comprises a hydrophilic polyurethane-based polymer.

6.  A radiant heat conduction-suppressing sheet according to any one of claims 1 to 5, wherein the heat conduction-suppressing layer has a shear adhesive strength at 80°C of 10 N/cm$^2$ or more.

7.  A radiant heat conduction-suppressing sheet according to any one of claims 1 to 6, wherein the heat conductive layer is selected from a graphite sheet and a metal foil.

8.  A radiant heat conduction-suppressing sheet according to any one of claims 1 to 7, wherein an area of the heat conductive layer is 4 or more times as large as an area of the heat radiating surface of the heating element, which the heat conductive layer faces.

FIG. 1

10

2

3

FIG. 2

11

2

3

FIG. 3

FIG. 4

FIG. 5

HEATING ELEMENT
(HEAT BLOCK)

SCREW FOR PRESSURE
ADJUSTMENT

LOAD CELL

TEMPERATURE SENSOR

ROD

TEST
PIECE

A ------- A'

TEMPERATURE
GAUGE

RADIATOR (COOLING
BASE PLATE)

PROBE

CONTACT TYPE
DISPLACEMENT GAUGE

A-A' CROSS SECTION OF
TEST PIECE

FIG. 6

HEATER

sample

1.8

1.0

4.0 mm

2.0 mm

TYPE T
THERMOCOUPLE

160 mm

25 mm

25 mm

140 mm

140 mm

160 mm

FIG.7

10.0kV 8.9mm x2.00k SE                    20.0um

Europäisches Patentamt
European Patent Office
Office européen des brevets

**EUROPEAN SEARCH REPORT**

Application Number

EP 13 17 1477

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | WO 2008/008939 A2 (PARKER HANNIFIN CORP [US]; FOSTER ROBERT H [US]; BUNYAN MICHAEL H [US]) 17 January 2008 (2008-01-17) * claim 1; figure 1 * | 1-8 | INV. B32B25/04 H05K7/20 |
| X | US 2003/198021 A1 (FREEDMAN PHILIP D [US]) 23 October 2003 (2003-10-23) * claims 1-21 * | 1,5,7 | |
| A | US 2012/048528 A1 (BERGIN JONATHAN [US] ET AL) 1 March 2012 (2012-03-01) * claims 1-4 * | 1-8 | |
| A,P | US 2012/261064 A1 (BODAY DYLAN J [US] ET AL) 18 October 2012 (2012-10-18) * claims 1,3 * | 1 | |
| A,P | DE 20 2012 103291 U1 (NMC SA [BE]) 10 September 2012 (2012-09-10) * paragraph [0014] * | 1 | |

TECHNICAL FIELDS SEARCHED (IPC)

B32B
H05K

The present search report has been drawn up for all claims

| Place of search | Date of completion of the search | Examiner |
|---|---|---|
| Munich | 18 September 2013 | Schweissguth, Martin |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

## ANNEX TO THE EUROPEAN SEARCH REPORT
## ON EUROPEAN PATENT APPLICATION NO.

EP 13 17 1477

This annex lists the patent family members relating to the patent documents cited in the above-mentioned European search report.
The members are as contained in the European Patent Office EDP file on
The European Patent Office is in no way liable for these particulars which are merely given for the purpose of information.

18-09-2013

| Patent document cited in search report | | Publication date | Patent family member(s) | | Publication date |
|---|---|---|---|---|---|
| WO 2008008939 | A2 | 17-01-2008 | CN | 101490840 A | 22-07-2009 |
| | | | GB | 2454837 A | 27-05-2009 |
| | | | JP | 2009544158 A | 10-12-2009 |
| | | | KR | 20090031724 A | 27-03-2009 |
| | | | US | 2008012103 A1 | 17-01-2008 |
| | | | WO | 2008008939 A2 | 17-01-2008 |
| US 2003198021 | A1 | 23-10-2003 | NONE | | |
| US 2012048528 | A1 | 01-03-2012 | CA | 2760003 A1 | 11-11-2010 |
| | | | CN | 102349151 A | 08-02-2012 |
| | | | EP | 2427906 A1 | 14-03-2012 |
| | | | JP | 2012526397 A | 25-10-2012 |
| | | | KR | 20120018740 A | 05-03-2012 |
| | | | US | 2012048528 A1 | 01-03-2012 |
| | | | WO | 2010129647 A1 | 11-11-2010 |
| US 2012261064 | A1 | 18-10-2012 | NONE | | |
| DE 202012103291 | U1 | 10-09-2012 | NONE | | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2012141184 A
- JP 3590758 B
- JP 4104887 B

- JP HEI101998229287 B
- JP 2003013015 A